# EUROPEAN PATENT SPECIFICATION

(11) **EP 3 863 384 B1**
(45) Date of publication and mention of the grant of the patent: **01.06.2022**
(21) Application number: 21154933.2
(22) Date of filing: 03.02.2021
(51) Int. Cl.: H05K 3/12, H05K 1/09, H05K 1/02

(54) **METHOD OF MANUFACTURING PRINTED WIRING BOARD**
VERFAHREN ZUR HERSTELLUNG EINER GEDRUCKTEN VERDRAHTUNGSPLATTE
PROCÉDÉ DE FABRICATION DE CARTE DE CÂBLAGE IMPRIMÉ

(30) Priority: 04.02.2020 JP 2020017033
(43) Date of publication of application: 11.08.2021
(73) Proprietor: Yazaki Corporation, Minato-ku Tokyo 108-8333 (JP)
(72) Inventor: AOYAMA, Yukito, Susono-shi, Shizuoka 410-1194 (JP); SATO, Shota, Susono-shi, Shizuoka 410-1194 (JP); TONE, Rie, Susono-shi, Shizuoka 410-1194 (JP); TASHIRO, Kosuke, Susono-shi, Shizuoka 410-1194 (JP); YAMAGUCHI, Toshio, Susono-shi, Shizuoka 410-1194 (JP)
(74) Representative: Grünecker Patent- und Rechtsanwälte PartG mbB

(56) References cited:
- EP-A2- 1 213 083
- JP-A- 2019 056 104
- US-A1- 2002 195 007
- US-A1- 2015 129 640
- US-A1- 2019 185 684

## Description

### TECHNICAL FIELD

The present invention relates to a method of manufacturing a printed wiring board.

### BACKGROUND

In recent years, a flexible printed wiring board (FPC) that can achieve miniaturization, thinning, and three-dimensionalization of a wire harness and peripheral parts thereof has been demanded in accordance with a reduction in a wiring space of a vehicle. In particular, in order to control a battery installed with electrical motorization of vehicles, a sensor module equipped with an FPC capable of detecting a current of each cell is required to be thin.

As an FPC that responds to demands for miniaturization, thinning, and three-dimensionalization there is known an FPC in which an electric circuit is formed by bonding a thin and soft base film with electrical insulation and a conductive metal such as copper foil. The circuit of the FPC is usually manufactured by a method called a subtractive method. For example, a circuit can be formed by bonding a metal foil such as copper to a polyimide film and etching the metal foil. Such a subtractive method requires complicated and very long processes such as photolithography, etching, and chemical vapor deposition, and thereby there is a problem in that a throughput is very low. Further, in the processes such as photolithography and etching, problems relating to the environment such as waste liquid are regarded as problems.

In order to solve the above-describe problems, an additive method, in the reverse of the subtractive method, in which a conductor pattern is formed on an insulating plate is examined. There are a plurality of kinds of the additive methods, and examples thereof include plating; printing a conductive paste or the like; depositing metal on a necessary part of a substrate; wiring a cable sheathed with polyimide on a substrate; and adhering a previously formed pattern to a substrate.

Among these additive methods, a printing method is exemplified as a method in which the throughput is the highest. In the printing method, an electric circuit is established by mainly using a film as a substrate, further using a conductive paste as a conductive wire material, and combining an insulating film, a resist, or the like therewith. Such a conductive paste includes a metal component, an organic solvent, a reducing agent, a resin component, and a wiring is formed by calcining after coating to enable conduction.

US 2019/185684 A1 discloses a method of manufacturing a printed wiring board, comprising applying a conductive paste to a surface of a substrate by screen printing, and curing the applied conductive paste to form wiring, wherein the conductive paste contains metal nanoparticles having an average particle diameter of 30 nm to 400 nm, metal particles having an average particle diameter of 1 µm to 5 µm, a thermosetting resin having an oxirane ring in a molecule, a curing agent, and a cellulose resin, wherein the wiring has a length of 100 mm, a width of 1 mm, a thickness of 30 µm.

US 2015/129640 A1, US 2002/195007 A1 and EP 1 213 083 A2 disclose methods of screen printing solder paste, wherein the squeegees have a cut-out portion in a corner portion.

JP 2013-134914 A discloses a conductive composition containing a thermoplastic resin and a thermosetting resin as a binder resin, a curing agent, and metal particles. WO 2017/033911 A discloses a metal paste obtained by kneading a solid content including silver particles and a solvent. A metal paste contains a predetermined amount of silver particles of which a particle diameter of 100 to 200 nm, and the average particle diameter of the whole silver particles is 60 to 800 nm, and as an additive, high molecular weight ethyl cellulose having a number average molecular weight in a predetermined range.

JP 2013-142173 A discloses that a silver compound and a predetermined amine mixture are mixed to form a complex compound containing the silver compound and the amine, and the complex compound is heated and thermally decomposed to form silver nanoparticles. In addition, JP 2013-142173 A discloses a silver coating composition containing the silver nanoparticles and an organic solvent. JP 2000-239636 A discloses a curable conductive paste containing an epoxy resin, a curing agent, conductive powder, and a solvent. JP 2012-84440 A discloses a thermosetting conductive paste containing (A) a conductive filler, (B) a thermosetting binder, (C) a cellulose resin, and (D) an acrylonitrile-butadiene copolymer if necessary.

### SUMMARY

Although the conductive paste contains a resin component in order to make the wiring adhere to the substrate, a general resin component has low conductivity, and therefore, an electrical resistance value of the wiring obtained from the conductive paste is approximately several to several tens of times larger than that of the copper foil. In particular, in a conductive paste mainly composed of micro-sized metal particles, the resistance value of the wiring may increase because there are few contact points between the metal particles. It is difficult to increase the film thickness of the wiring obtained from the conductive paste, and the film thickness of the wiring is often about several micrometres. In particular, in a conductive paste mainly composed of nano-sized metal particles, it is difficult to increase the film thickness of the wiring.

Therefore, even if a conductive paste of the prior art is used, when long and narrow wiring is formed, it is difficult to obtain a printed wiring board that can be used with a high current. In order to apply a flexible printed wiring board to a vehicle, a stable circuit quality with a long length of about 100 mm to 1600 mm and a resistance value of 1000 mΩ/m or less is required. However, in a large flexible circuit body such as that used in a vehicle, it is difficult to stably form such a circuit quality by a printing method. Therefore, the conductive paste as described above is usually applied to a circuit in which the length of the wiring is 100 mm or less and even a high resistance value is acceptable.

The present invention has been made in view of the problems in the related art. An object of the present invention is to provide a method of manufacturing a printed wiring board that can be used with a high current even in long and narrow wiring.

The method of manufacturing a printed wiring board according to the invention is defined in claim 1.

The printed wiring board includes a substrate, and wiring provided on a surface of the substrate and including a cured conductive paste containing metal nanoparticles having an average particle diameter of 30 nm or more and 600 nm or less, metal particles having an average particle diameter larger than that of the metal nanoparticles, a thermosetting resin having an oxirane ring in a molecule, a curing agent, and a cellulose resin. In this printed wiring board, the wiring has a length of 100 mm or more and 1600 mm or less, a width of 0.3 mm or more and 3 mm or less, a thickness of 10 µm or more and 40 µm or less, and a resistance value of 1000 mΩ/m or less.

The thermosetting resin having the oxirane ring in the molecule may be at least one selected from the group consisting of a bisphenol A type epoxy resin, a bisphenol F type epoxy resin, a novolac type epoxy resin, a glycidylamine type epoxy resin, and an aliphatic type epoxy resin.

The average particle diameter of the metal particles may be 1 µm or more and 5 µm or less.

A printed circuit board includes the printed wiring board and an electronic component connected to the substrate of the printed wiring board via the wiring.

A method of manufacturing a printed wiring board according to the present invention includes applying a conductive paste to a surface of a substrate, and curing the applied conductive paste to form wiring. In this manufacturing method, the conductive paste contains metal nanoparticles having an average particle diameter of 30 nm or more and 600 nm or less, metal particles having an average particle diameter larger than that of the metal nanoparticles, a thermosetting resin having an oxirane ring in a molecule, a curing agent, and a cellulose resin, and the wiring has a length of 100 mm or more and 1600 mm or less, a width of 0.3 mm or more and 3 mm or less, a thickness of 10 µm or more and 40 µm or less, and a resistance value of 1000 mΩ/m or less.

According to the present disclosure, it is possible to provide a method of manufacturing a printed wiring board that can be used with a high current even in long and narrow wiring.

### BRIEF DESCRIPTION OF THE DRAWINGS

FIG. 1 is a plan view illustrating an example of a printed wiring board;
FIG. 2 is a side view illustrating an example of a state of screen printing using a squeegee having a cut-out portion; and
FIG. 3 is a plan view illustrating the printed wiring board produced in an example.

### DETAILED DESCRIPTION

Hereinafter, a printed wiring board, a printed circuit board, and methods of manufacturing the printed wiring board and the printed circuit board will be described in detail with reference to the drawings. The dimensional ratios in the drawings are exaggerated for convenience of explanation, and some of the ratios are different from actual ones.

### [Printed wiring board]

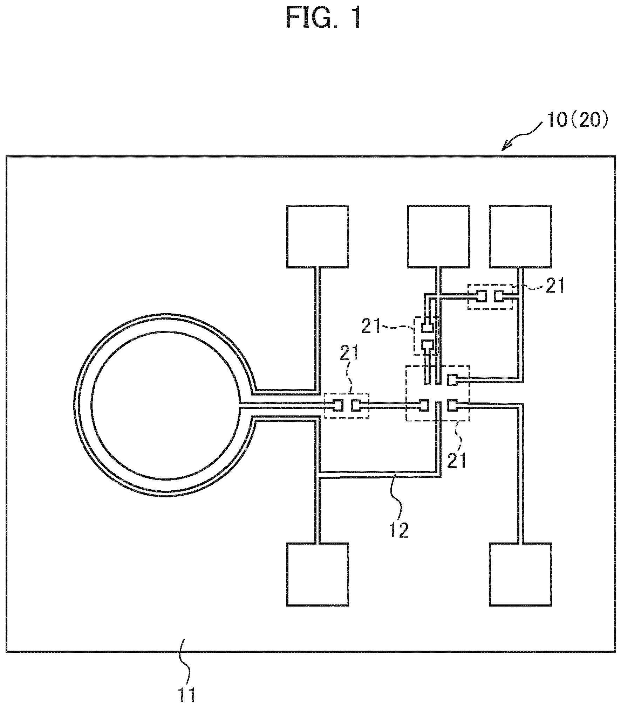

First, the printed wiring board will be described. As shown in FIG. 1, a printed circuit board 20 includes a printed wiring board 10 and an electronic component 21. The printed wiring board 10 includes a substrate 11 and wiring 12.

### (Substrate)

The substrate 11 that can be used for the printed wiring board 10 is not particularly limited, and an electrically insulating film or a plate material can be used. Such a substrate 11 is flexible and can be bent or the like depending on the portion to be used. The material of the substrate 11 is not particularly limited, for example, it is possible to use at least one selected from the group consisting of polyimide (PI), polyethylene terephthalate (PET), polyethylene naphthalate (PEN), polycarbonate (PC), polypropylene (PP), and polybutylene terephthalate (PBT).

### (Wiring)

The wiring 12 is provided on a surface of the substrate 11. The wiring 12 has a length of 100 mm or more and 1600 mm or less, a width of 0.3 mm or more and 3 mm or less, a thickness of 10 µm or more and 40 µm or less, and a resistance value of 1000 mΩ/m or less. The length, width, thickness, and resistance value of the wiring 12 may be the same or different depending on the position of the wiring 12.

The length of the wiring 12 is 100 mm or more and 1600 mm or less. When the length of the wiring 12 is 100 mm or more, the wiring 12 can be applied to large circuit wiring for vehicle applications and the like. Furthermore, when the length of the wiring 12 is 1600 mm or less, it is less necessary to apply a high voltage to the wiring 12, and it is easy to apply the wiring 12 to vehicle applications and the like. The length of the wiring 12 may be 200 mm or more, or 400 mm or more. Furthermore, the length of the wiring 12 may be 1000 mm or less, or 600 mm or less.

The width of the wiring 12 is 0.3 mm or more and 3 mm or less. Since the width of the wiring 12 is 0.3 mm or more, it is suppressed that the resistance value of the wiring 12 becomes too high. Furthermore, since the width of the wiring 12 is 3 mm or less, the wiring 12 can be arranged even in a narrow space, so that space saving can be promoted. The width of the wiring 12 may be 0.6 mm or more, or 1.0 mm or more. Furthermore, the width of the wiring 12 may be 2.0 mm or less, or 1.5 mm or less.

The thickness of the wiring 12 is 10 µm or more and 40 µm or less. As described above, it is difficult to increase the film thickness of the wiring obtained from a conventional conductive paste, and the film thickness of the wiring is often about several micrometres. In particular, in the conventional conductive paste mainly composed of nano-sized metal particles, it is difficult to increase the film thickness of the wiring. However, according to the conductive paste described later, the thickness of the wiring 12 can be 10 µm or more. Since the thickness of the wiring 12 is 10 µm or more, it is suppressed that the resistance value of the wiring 12 becomes too high. When the thickness of the wiring 12 is 40 µm or less, flexibility of the printed wiring board 10 can be increased. Furthermore, when the thickness of the wiring 12 is 40 µm or less, it becomes easy to sheath the wiring 12 with an insulating cover. The thickness of the wiring 12 may be 15 µm or more, or 20 µm or more. Furthermore, the thickness of the wiring 12 may be 30 µm or less, or 25 µm or less.

A resistance value of the wiring 12 is 1000 mΩ/m or less. Although the wiring obtained from the conventional conductive paste has a length of 100 mm or more and 1600 mm or less, a width of 0.3 mm or more and 3 mm or less, and a thickness of 10 µm or more and 40 µm or less, it is difficult to set the resistance value of the wiring to 1000 mΩ/m or less. However, according to the conductive paste described later, the resistance value of the wiring 12 can be set to 1000 mΩ/m or less. Since the resistance value of the wiring 12 is 1000 mΩ/m or less, even when a high voltage of about 12 V is applied to the wiring 12, heat generation of the wiring 12 is unlikely to occur, so that the wiring 12 can be applied to vehicle applications and the like. The lower the resistance value of the wiring 12, the more preferable. Therefore, the lower limit of the resistance value of the wiring 12 is 0 mΩ/m. The resistance value of the wiring 12 may be 800 mΩ/m or less, or 600 mΩ/m or less.

The wiring 12 is made by curing the conductive paste. The wiring 12 may contain metal nanoparticles, metal particles, a first resin, and a second resin. The wiring 12 is a conductor made by curing the conductive paste. As will be described later, the conductive paste contains metal nanoparticles, metal particles, a thermosetting resin, a curing agent, and a cellulose resin. In the present embodiment, since the wiring 12 has such a composition, weldability of the electronic component 21 to the substrate 11 can be increased.

### (Metal nanoparticles)

Metal nanoparticles have an average particle diameter of 30 nm or more and 600 nm or less. Since the metal nanoparticles have such an average particle diameter, a gap between the metal particles can be filled with the metal nanoparticles, and a dense sintered body is formed, so that conductivity of the wiring 12 can be improved. Note that, the average particle diameter of the metal nanoparticles is more preferably 70 nm or more and 600 nm or less from the viewpoint of forming a denser sintered body and increasing the conductivity. The average particle diameter of the metal nanoparticles can be measured by observing the metal nanoparticles with a scanning electron microscope.

The metal constituting the metal nanoparticle is not particularly limited, and is preferable to contain at least one selected from the group consisting of gold, silver, copper, platinum, palladium, rhodium, ruthenium, iridium, osmium, tungsten, nickel, tantalum, bismuth, lead, indium, tin, zinc, and titanium. Further, the metal constituting the metal nanoparticle more preferably consists of at least one selected from the group consisting of gold, silver, copper, platinum, palladium, rhodium, ruthenium, iridium, osmium, tungsten, nickel, tantalum, bismuth, lead, indium, tin, zinc, and titanium. Furthermore, it is preferable that the metal consisting of a metal nanoparticle contains at least one selected from the group consisting of gold, silver, copper, and platinum. By using such metal nanoparticles, fine wiring 12 can be formed. In addition, by using metal nanoparticles such as these, the resistance value of the wiring 12 can be reduced, and surface smoothness of the wiring 12 can be improved. Among these metals, it is preferable to use silver as the metal nanoparticles from the viewpoint of reducing the resistance value of the wiring 12.

The content of the metal nanoparticles in the wiring 12 may be 10% by mass or more, 20% by mass or more, or 30% by mass or more. Furthermore, the content of the metal nanoparticles in the wiring 12 may be 50% by mass or less, or 40% by mass or less.

### (Metal particles)

Metal particles have an average particle diameter larger than that of metal nanoparticles. By using such metal particles, the wiring 12 can be densified, and the resistance value of the wiring 12 can be reduced.

The average particle diameter of the metal particles is preferably 1 µm or more and 5 µm or less. When the average particle diameter of the metal particles is within this range, the conductivity of the wiring 12 can be increased. The average particle diameter of the metal particles can be measured by observing the metal particles with a scanning electron microscope.

Similar to the metal nanoparticle, the metal constituting the metal particle is preferable to contain at least one selected from the group consisting of gold, silver, copper, platinum, palladium, rhodium, ruthenium, iridium, osmium, tungsten, nickel, tantalum, bismuth, lead, indium, tin, zinc, and titanium. Further, the metal constituting the metal particle more preferably consists of at least one selected from the group consisting of gold, silver, copper, platinum, palladium, rhodium, ruthenium, iridium, osmium, tungsten, nickel, tantalum, bismuth, lead, indium, tin, zinc, and titanium. Furthermore, it is preferable that the metal consisting of a metal particle contains at least one selected from the group consisting of gold, silver, copper, and platinum. By using metal particles including of these metals, the resistance value of the wiring 12 can be reduced, and the surface smoothness of the wiring 12 can be improved. Among these metals, it is preferable to use silver as the metal particles from the viewpoint of reducing specific resistance of the wiring 12.

The content of the metal particles in the wiring 12 may be 10% by mass or more, 20% by mass or more, or 30% by mass or more. Furthermore, the content of the metal particles in the wiring 12 may be 50% by mass or less, or 40% by mass or less.

The ratio of the metal nanoparticles to the metal particles is not particularly limited, and is preferably, for example, 1:9 or more and 9:1 or less by mass ratio. When the ratio of the metal nanoparticles to the metal particles is within this range, the wiring 12 made of a dense sintered body and having improved conductivity can be obtained. In addition, in a case where the ratio of the metal nanoparticles is lower than this range, it may become difficult to satisfy the specific resistance of the wiring 12 to be obtained. On the other hand, when the ratio of the metal nanoparticles is higher than this range, the viscosity of the conductive paste is lowered, and it may be difficult to satisfy the workability.

A ratio of a total content of the metal nanoparticles to the metal particles in the wiring 12 may be 80% by mass or more, 85% by mass or more, or 90% by mass or more. The ratio of the total content of the metal nanoparticles to the metal particles in the wiring 12 may be 99.9% by mass or less, 99% by mass or less, or 98% by mass or less.

### (First resin)

The first resin is a resin produced by reacting molecules having an oxirane ring with each other. Oxirane is 3-membered ring ether that is also called ethylene oxide. By using such molecules, adhesion between the substrate 11 and the wiring 12 can be improved.

The molecule having an oxirane ring is not particularly limited, and is preferably at least one selected from the group consisting of a bisphenol A type epoxy resin, a bisphenol F type epoxy resin, a novolac type epoxy resin, a glycidylamine type epoxy resin, and an aliphatic type epoxy resin.

The content of the first resin in the wiring 12 may be 0.1% by mass or more, or 1% by mass or more. Furthermore, the content of the first resin in the wiring 12 may be 10% by mass or less, or 5% by mass or less.

### (Second resin)

The second resin is a cellulose resin. By uniformly dispersing the cellulose resin in the conductive paste, it is possible to suppress the fluidity of the conductive paste from increasing and the printability of the conductive paste from decreasing. Moreover, since the thermosetting resin and the curing agent are entangled with each other by uniformly dispersing the cellulose resin in the conductive paste, the adhesion between the wiring 12 formed by calcining the conductive paste and the substrate 11 can be improved.

Examples of the cellulose resin include cellulose ether, cellulose ester, and cellulose ether ester, and it is preferable to use cellulose ether. Examples of the cellulose ether include cellulose single ether in which one kind of ether group is bonded to cellulose and cellulose mixed ether in which two or more kinds of ether groups are bonded to cellulose. Specific examples of the cellulose single ether include methyl cellulose, ethyl cellulose, propyl cellulose, hydroxymethyl cellulose, hydroxyethyl cellulose, hydroxypropyl cellulose, and carboxymethyl cellulose. Specific examples of the cellulose mixed ether include methyl ethyl cellulose, methyl propyl cellulose, ethyl propyl cellulose, hydroxymethyl ethyl cellulose, hydroxypropyl methyl cellulose, hydroxyethyl methyl cellulose, and hydroxypropyl methyl cellulose. The cellulose ether may be used alone and may be used in combination of two or more kinds thereof. Note that, a cellulose resin is preferably ethyl cellulose.

The content of the cellulose resin in the wiring 12 may be 0.1% by mass or more, or 0.5% by mass or more. Furthermore, the content of the cellulose resin in the wiring 12 may be 5% by mass or less, or 3% by mass or less.

The wiring 12 may be provided on both surfaces of the substrate 11. That is, the substrate 11 may have a first surface and a second surface opposite to the first surface, and the wiring 12 may be provided on the first surface and the second surface. According to such a printed wiring board 10, it is possible to provide a complicated circuit.

The substrate 11 has a curved surface, and the wiring 12 may be provided on the curved surface. Such a printed wiring board 10 can be applied to a component having a curved surface shape, and can provide a center console or a map lamp having a curved surface shape with a high design property.

### (Insulating cover material)

The printed wiring board 10 provided with the wiring 12 may include an insulating cover material for covering and protecting the surface of the wiring 12. An insulating film or a resist can be used as the insulating cover material. As the insulating cover material, it is preferable to use polyimide (PI), polyethylene terephthalate (PET), polyethylene naphthalate (PEN), polycarbonate (PC), polypropylene (PP), polybutylene terephthalate (PBT), polyurethane (PU), and the like with an adhesive on one side. In addition, the resist is preferably a thermosetting resist or a UV curable resist, and particularly preferably an epoxy resist or a urethane resist.

As described above, the printed wiring board 10 includes the substrate 11 and the wiring 12 provided on the surface of the substrate 11 and including the cured conductive paste. The conductive paste contains metal nanoparticles having an average particle diameter of 30 nm or more and 600 nm or less, metal particles having an average particle diameter larger than that of the metal nanoparticles, a thermosetting resin having an oxirane ring in a molecule, a curing agent, and a cellulose resin. The wiring 12 has a length of 100 mm or more and 1600 mm or less, a width of 0.3 mm or more and 3 mm or less, a thickness of 10 µm or more and 40 µm or less, and a resistance value of 1000 mΩm or less.

As described above, the wiring 12 obtained by printing and curing the conventional conductive paste has a resistance value approximately several to several tens of times larger than that of a copper foil, and the film thickness of the wiring 12 is also often about several micrometres. It is necessary to apply a low voltage to such a printed wiring board so as not to generate heat and adversely affect a control system.

On the other hand, in the printed wiring board 10 obtained by the method of the present invention, since the resistance of the wiring 12 is small, heat generation is unlikely to occur even when a voltage of about 12 V is applied. Therefore, the printed wiring board 10 can be used with a high current even when long and narrow wiring is formed. In order to control a battery installed with electrical motorization of electric vehicles, such a printed wiring board 10 can be applied to a sensor module capable of detecting a current of each cell.

### [Printed circuit board]

Next, the printed circuit board will be described. The printed circuit board 20 includes the printed wiring board 10 and the electronic component 21 connected to the substrate 11 of the printed wiring board 10 via the wiring 12.

### (Electronic component)

As the electronic component 21, a known component that can be used in an electronic circuit can be used. The electronic component 21 may be, for example, an active component such as an integrated circuit, a transistor or a diode, a passive component such as a resistor or a capacitor, or a combination thereof.

### [Method of manufacturing printed wiring board]

Next, a method of manufacturing the printed wiring board 10 will be described. The method of manufacturing the printed wiring board 10 according to the present embodiment includes a step of applying a conductive paste to the surface of the substrate 11 and a step of curing the applied conductive paste to form the wiring 12.

### (Conductive paste)

The conductive paste contains metal nanoparticles, metal particles, a thermosetting resin, a curing agent, and a cellulose resin.

### (Metal nanoparticles)

As the metal nanoparticles, the above-described materials can be used. The conductive paste contains metal nanoparticles having an average particle diameter of 30 nm or more and 600 nm or less. Usually, a metal melting point decreases because the number of metal atoms present on the particle surface increases as the diameter of the metal particle decreases. Therefore, it is possible to form the wiring 12 at a relatively low temperature by using such metal nanoparticles for the conductive paste. Further, when the average particle diameter of the metal nanoparticles is 30 nm or more and 600 nm or less, a gap between the metal particles can be filled with the metal nanoparticles. Therefore, since the metal nanoparticles and the metal particles are sintered to form a dense sintered body, the conductivity of the wiring 12 obtained by calcining the conductive paste can be increased. Note that, the average particle diameter of the metal nanoparticles is more preferably 70 nm or more and 600 nm or less from the viewpoint of forming a denser sintered body and increasing the conductivity.

### (Metal particles)

As the metal particles, the above-described materials can be used. Metal particles have an average particle diameter larger than that of metal nanoparticles. By using such metal particles, the wiring 12 can be densified, and the resistance value of the wiring 12 can be reduced. The average particle diameter of the metal particles is preferably 1 µm or more and 5 µm or less. When the average particle diameter of the metal particles is within this range, the conductivity of the wiring 12 can be increased. In addition, as described later, even in a case where the conductive paste is applied to the insulating substrate 11 by a screen printing method, a fine circuit can be efficiently formed due to little possibility of clogging metal particles in the screen printing mesh.

### (Thermosetting resin)

The conductive paste according to the present embodiment contains a thermosetting resin having an oxirane ring in the molecule. By using such a thermosetting resin, in when the wiring 12 is formed by applying and curing the conductive paste to the substrate 11, the adhesion between the substrate 11 and the wiring 12 can be improved.

The thermosetting resin having an oxirane ring in the molecule is not particularly limited, and is preferably at least one selected from the group consisting of a bisphenol A type epoxy resin, a bisphenol F type epoxy resin, a novolac type epoxy resin, a glycidylamine type epoxy resin, and an aliphatic type epoxy resin.

### (Curing agent)

The curing agent is not particularly limited as long as the thermosetting resin contained in the conductive paste can be cured. For example, an imidazole curing agent, an amide curing agent, a phenol curing agent, an amine curing agent, an acid anhydride curing agent, or the like can be used for the curing agent. The curing agent may be used alone and may be used in combination of two or more kinds thereof.

Examples of the imidazole curing agent include imidazole, 2-methylimidazole, 2-ethylimidazole, 2-ethyl-4-methylimidazole, 2-isopropylimidazole, 2-phenylimidazole, 1-cyanoethyl-2-undecylimidazole, 1-cyano-2-phenylimidazole, 1-cyanoethyl-2-undecylimidazole trimellitate, and 1-cyanoethyl-2-phenylimidazolium trimellitate.

Examples of the amide curing agent include dicyandiamide.

Examples of the phenol curing agent include a phenol resin.

Examples of the amine curing agent include aliphatic amines such as diethylenetriamine, triethylenetetramine, tetraethylenepentamine, and N-aminoethylpiperazine, and aromatic amines such as toluenediamine, xylenediamine, diaminodiphenylmethane, phenylenediamine, and diaminodiphenylsulfone.

Examples of the acid anhydride curing agent include phthalic anhydride, trimellitic anhydride, tetrahydrophthalic anhydride, methyltetrahydrophthalic anhydride, methylhexahydrophthalic anhydride, hexahydrophthalic anhydride, and nadic anhydride.

The curing agent is preferably a 5-membered heterocyclic aromatic compound containing nitrogen. The 5-membered heterocyclic aromatic compound containing nitrogen is a heterocyclic compound containing carbon and nitrogen, having a 5-membered ring, and having aromaticity. Since such a curing agent generally has a curing start temperature of 100°C or higher, even when a conductive paste is prepared and applied to the substrate 11 or the like, curing does not easily start at room temperature, and the curing is easy to start after calcining. Therefore, when the printed wiring board 10 is manufactured, the conductive paste can be easily handled. As the curing agent of the 5-membered heterocyclic aromatic compound containing nitrogen, the imidazole curing agent is mentioned, for example.

The content ratio of the thermosetting resin to the curing agent is preferably 1:1 or more and 4:1 or less by mass ratio. By setting the content ratio of the thermosetting resin to the curing agent to be within the above range, the reactivity between the thermosetting resin and the curing agent is further improved, so that the curing of the conductive paste can be promoted. Note that, the content ratio of the thermosetting resin to the curing agent is more preferably 1:1 or more and 3:1 or less by mass ratio.

### (Cellulose resin)

The conductive paste contains a cellulose resin. By uniformly dispersing the cellulose resin in the conductive paste, it is possible to suppress the fluidity of the conductive paste from increasing and the printability of the conductive paste from decreasing. Moreover, since the thermosetting resin and the curing agent are entangled with each other by uniformly dispersing the cellulose resin in the conductive paste, the adhesion between the wiring 12 formed by calcining the conductive paste and the substrate 11 can be improved.

Although the content of the cellulose resin in the conductive paste is not particularly limited, it is preferable to prepare so that the printability of a conductive paste may become favorable. Specifically, the content of the cellulose resin is preferably 0.1% by mass or more and 4% by mass or less with respect to the entire conductive paste. When the content of the cellulose resin is 0.1% by mass or more, the adhesion between the wiring 12 formed by calcining the conductive paste and the substrate 11 can be further improved. Moreover, when content of a cellulose resin is 4% by mass or less, the fluidity of the conductive paste can be prevented from excessively rising, and the printability of the conductive paste can be improved. Further, when the content of the cellulose resin is 4% by mass or less, the content of the relative metal component in the wiring 12 increases, so that the conductivity of the wiring 12 can be improved. The content of the cellulose resin is more preferably 0.1% by mass or more and 2% by mass or less with respect to the entire conductive paste.

### (Organic solvent)

The conductive paste of the present embodiment may contain an organic solvent in order to uniformly disperse the metal nanoparticles, metal particles, a thermosetting resin, a curing agent, and a cellulose resin. The organic solvent is not particularly limited as long as it can highly disperse the metal nanoparticles and metal particles and dissolve the thermosetting resin, the curing agent, and the cellulose resin.

As the organic solvent, it is preferable to use an organic solvent having 8 or more and 16 or less carbon atoms in total, a hydroxyl group, and a boiling point of 280°C or lower. Specifically, as the organic solvent, it is possible to use at least one selected from the group consisting of diethylene glycol monoethyl ether acetate (C8, boiling point of 218°C), terpineol (C10, boiling point of 219°C), dihydroterpineol (C10, boiling point of 220°C), texanol (C12, boiling point of 260°C), 2,4-dimethyl-1,5-pentadiol (C9, boiling point of 150°C), and butyl carbitol (C8, boiling point of 230°C). In addition, as the organic solvent, it is also possible to use at least one selected from the group consisting of isophorone (boiling point of 215°C), ethylene glycol (boiling point of 197°C), butyl carbitol acetate (boiling point of 247°C), and 2,2,4-trimethyl-1,3-pentanediol diisobutyrate (C16, boiling point of 280°C).

The additional amount of the organic solvent in the conductive paste is not particularly limited, and it is preferable to prepare the viscosity so that the conductive paste can be applied by a screen printing method or the like. Specifically, the content of the organic solvent is preferably 10% by mass or more and 25% by mass or less with respect to the entire conductive paste.

The conductive paste of the present embodiment may contain additives such as an antifoaming agent, a surfactant, a rheology modifier to improve printing characteristics and conductor characteristics within a range that does not adversely affect the dispersion stability of the paste and the performance of the wiring 12 after calcining.

As described above, the conductive paste includes a metal component such as metal nanoparticles and metal particles, and a resin component such as a thermosetting resin, a curing agent, and a cellulose resin. Then, the wiring 12 is formed by calcining after applying the conductive paste to the substrate 11. At this time, it is preferable to add a certain amount of a resin component to the conductive paste in order to improve the adhesion between the obtained wiring 12 and the substrate 11.

Here, a solder is easy to bond with metal, while being difficult to bond with resin. For this reason, the resin component may reduce the wettability between the wiring 12 and the solder during mounting, thereby making it difficult to form a fillet shape or forming a solder ball. In such a case, a bonding strength between the wiring 12 and the mounted component may not be satisfied.

From such a viewpoint, the total content of the thermosetting resin and the curing agent is preferably 0.1% by mass or more and 6% by mass or less with respect to the entire conductive paste. When the total content is 0.1% by mass or more, the adhesion between the wiring 12 formed by calcining the conductive paste and the substrate 11 can be further improved. Further, when the total content is 6% by mass or less, the content of the relative metal component in the wiring 12 increases, so that the conductivity of the wiring 12 can be improved.

In addition, the total content of the thermosetting resin and the curing agent is more preferably 0.1% by mass or more and 5% by mass or less, further preferably 0.1% by mass or more and 4% by mass or less, and is particularly preferably 0.1% by mass or more and 2% by mass or less, with respect to the entire conductive paste. By setting the total content of the thermosetting resin and the curing agent within this range, the resin component in the obtained wiring 12 is reduced, so that the wettability of the solder to the wiring 12 can be improved. That is, by reducing the resin component in the entire conductive paste, the metal nanoparticles and the metal particles are easily brought into contact with each other, and sintering is promoted, so that the pores are reduced in a size to obtain the wiring 12 having a high metal concentration. Such a wiring 12 makes it possible to satisfy contradictory characteristics such as adhesion to the substrate 11 and wettability of solder. In addition, since such a wiring 12 has a small amount of flux that appears on the surface after calcining, the excellent solder wettability is possible.

Since the length of the wiring 12 is 100 mm or more and 1600 mm or less, it is preferable that the shape of the wiring 12 can be stably formed. In order to stably form the wiring 12, the thickness of the substrate 11 is preferably 100 µm or more and 250 µm or less in order to suppress deformation due to combustion or the like. Furthermore, in order to stably form the wiring 12, it is preferable to anneal the substrate 11 in advance. Although the condition of the annealing treatment differs depending on the type of the substrate 11 to be used, it is preferable to carry out the annealing treatment at a calcining temperature of about + 10°C, which will be described later, for about 30 minutes. For example, when a PI film is used, it is preferable to perform heating at 250°C or higher and 350°C or lower for a time of 15 minutes or more and 60 minutes or less.

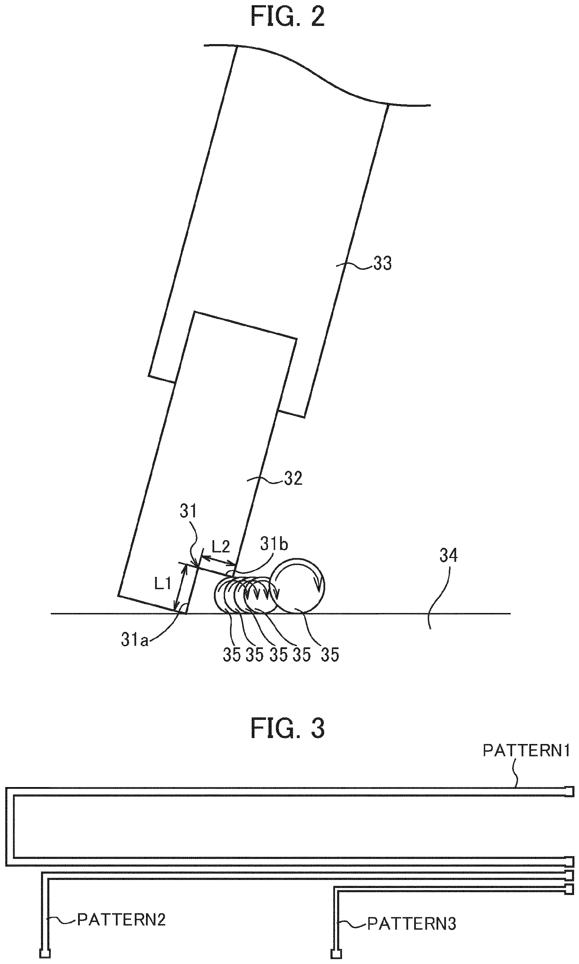

According to the invention, the conductive paste is applied onto the substrate 11 by screen printing. A squeegee 32 having an L-shaped cut-out portion 31 in which a portion of a corner portion is cut off as illustrated in FIG. 2 may be used. The squeegee 32 is held by a squeegee holder 33, and the cut-out portion 31 is provided at one corner portion of the squeegee 32 on a side opposite to the squeegee holder 33. The cut-out portion 31 is formed by a first outer surface 31a and a second outer surface 31b that are orthogonal to each other and extend in a depth direction of the drawing. A length L1 in a perpendicular direction of the first outer surface 31a and a length L2 in a perpendicular direction of the second outer surface 31b may be the same or different. The length L1 and the length L2 are, for example, each 1.5 mm to 3.5 mm. In FIG. 2, an interior angle formed by the first outer surface 31a and the second outer surface 31b is 90 degrees; however, the interior angle may be 45 degrees to 135 degrees. The cut-out portion 31 does not have to be formed by two surfaces, and may be formed by three or more outer surfaces.

The squeegee 32 is arranged so that the portion where the cut-out portion 31 is formed is in contact with a screen plate 34. By arranging the squeegee 32 and the screen plate 34 in contact with each other, a small space is formed between the cut-out portion 31 and the screen plate 34. When the squeegee 32 is moved in a direction of the space along a surface of the screen plate 34, the conductive paste is rolled by the squeegee 32, and a conductive paste 35 having a predetermined rolling diameter is formed. At this time, the rolling diameter of the conductive paste 35 is reduced by the small space between the cut-out portion 31 and the screen plate 34, regardless of an amount of the conductive paste pasted on the screen plate 34. Since a rolling speed increases as the rolling diameter of the conductive paste decreases, the fluidity of the conductive paste during screen printing is improved as compared with a case where the squeegee 32 is not provided with the cut-out portion 31. Therefore, resistance when the conductive paste is transmitted through the screen plate 34 is reduced, and the wiring 12 having a uniform thickness can be printed on the substrate 11 at high speed.

A calcining method after applying the conductive paste on the substrate 11 is also not specifically limited. For example, it is preferable to expose the substrate 11 coated with the conductive paste to hot air of 140°C or higher. With this, since the organic solvent or the like in the conductive paste is removed and the metal nanoparticles and the metal particles are sintered, the wiring 12 having high conductivity can be obtained. It is more preferable to expose the substrate 11 coated with the conductive paste to hot air of 250°C or higher. By raising the calcining temperature, the obtained sintered body becomes denser, and therefore it is possible to further reduce the resistance. Note that, the calcining method is not limited to the above-described hot-air calcining, and for example, plasma calcining, light calcining, and pulse wave calcining can also be applied.

### [Method of manufacturing printed circuit board]

The printed circuit board 20 is obtained by mounting the electronic component 21 on the printed wiring board 10. The method of mounting the electronic component 21 on the printed wiring board 10 is not particularly limited, and the electronic component 21 may be connected to the substrate 11 of the printed wiring board 10 via the wiring 12 by, for example, soldering.

### [Example]

Hereinafter, the present disclosure will be described in more detail with reference to examples and comparative examples, but the present disclosure is not limited to these examples.

### [Preparation of conductive paste]

First, a conductive paste of each example was prepared by stirring metal nanoparticles, metal particles, the first resin, a curing agent, the second resin, and an organic solvent at a compounding ratio indicated in Tables 1 to 6 using a rotation and revolution stirrer. The materials used as raw materials of the conductive pastes of each example are as follows.

### (Metal nanoparticles)

Silver nanoparticles having average particle diameters of 25 nm, 30 nm, 70 nm, 350 nm, 600 nm, and 700 nm

### (Metal particles)

Silver particles having average particle diameters of 1.0 µm, 3.0 µm, and 5.0 µm

### (First resin)

- Bisphenol A type epoxy resin, jER (registered trademark) 828, manufactured by Mitsubishi Chemical Corporation
- Bisphenol F type epoxy resin, EPICLON (registered trademark) 830, manufactured by DIC Corporation
- Aliphatic epoxy resin, PG-207GS (polypropylene glycol diglycidyl ether) manufactured by NIPPON STEEL Chemical & Material Co., Ltd.
- Novolac type epoxy resin, YDPN-638 (phenol Novolac type epoxy resin), manufactured by NIPPON STEEL Chemical & Material Co., Ltd.
- Phenolic resin, PS-2608, manufactured by Gun Ei Chemical Industry Co., Ltd.
- Urethane resin, UREARNO (registered trademark) KL-422, manufactured by Arakawa Chemical Industries, Ltd.

### (Curing agent)

- Dicyandiamide, DICY7, manufactured by Mitsubishi Chemical Corporation
- Imidazole, NISSOCURE (registered trademark) TIC-188, manufactured by Nippon Soda Co., Ltd.
- Hexamethylenetetramine, manufactured by Mitsubishi Gas Chemical Company, Inc.
- Polyisocyanate, BURNOCK (registered trademark) D-750, manufactured by DIC Corporation

### (Second resin)

- Hydroxyethylmethylcellulose, METOLOSE (registered trademark) SEB04T, manufactured by Shin-Etsu Chemical Co., Ltd.
- Ethyl cellulose, ETHOCEL (registered trademark) STD4, manufactured by The Dow Chemical Company
- Ethyl cellulose acrylic polymer, ACRIT (registered trademark) KWE-250T, manufactured by Taisei Fine Chemical Co., Ltd.
- Polyamide, F-915, manufactured by Tokyo Printing Ink Mfg. Co., Ltd.
- Acrylic resin, ACRYDIC (registered trademark) 52-204, manufactured by DIC Corporation

### (Organic solvent)

- Terpineol, manufactured by Tokyo Chemical Industry Co., Ltd.
- Diethylene glycol monoethyl ether acetate, manufactured by Tokyo Chemical Industry Co., Ltd.
- Texanol (2,2,4-trimethylpentane-1,3-diol monoisobutyrate) manufactured by Eastman Chemical Company

### [Evaluation]

The conductive paste of each example was evaluated as follows. These results are indicated in Tables 1 to 6.

### (Specific resistance of wiring)

The specific resistance of the wiring was measured in accordance with JIS K7194. As a device, a four-probe resistance measuring instrument (resistivity measuring device Sigma-5 + manufactured by NPS Corporation) was used.

Specifically, first, wiring was printed with the conductive paste obtained in each example on a substrate of a polyimide film using a screen printer so that the width was 1 mm, the length was 10 cm, and the thickness was 30 µm after calcining. Next, after the substrate on which the wiring was printed was allowed to stand at room temperature for 30 minutes, it was calcined with hot air at 140°C for 30 minutes to produce a printed wiring board.

Next, the surface resistance of the obtained Ag thin film on the printed wiring board was measured at three points, 1 cm portions from both ends and a 5 cm portion at the center. Note that, the surface resistance was measured with the needle placed parallel to the wiring.

### (Adhesion)

The adhesion of the conductive paste to the substrate was evaluated by a peeling test using a tape having an adhesive force of 3.9 N/10 mm or more and 5.7 N/10 mm or less.

Specifically, first, wiring was printed with the conductive paste obtained in each example on a substrate using a screen printer so that the width was 1 mm, the length was 10 cm, and the thickness was 30 µm after calcining. After the substrate on which the wiring was printed was allowed to stand at room temperature for 30 minutes, it was calcined with hot air at 140°C for 30 minutes to produce a printed wiring board.

Next, the adhesive surface of the tape was pressure-bonded to the obtained printed wiring board with fingers so that no bubbles remained, and after about 10 seconds, the tape was quickly peeled off in a direction perpendicular to the printed surface. As a tape, an aluminum tape No. 950, manufactured by Nichiban Co., Ltd., with an adhesive force of 5.30 N/10 mm was used.

### • Criteria

A: No print peeling is observed (a case where the peeled wiring cannot be checked on the tape side and a case where the peeling of the wiring cannot be checked visually on the printed wiring board side)
B: Print peeling is observed (a case where the peeled wiring can be checked on the tape side or a case where the peeling of the wiring can be checked visually on the printed wiring board side)

**[Table 1]**

| | Details of materials | Example 1-1 | Example 1-2 | Example 1-3 | Example 1-4 | Example 1-5 |
|---|---|---|---|---|---|---|
| Silver nanoparticle (part(s) by mass) | 25nm | - | - | - | - | - |
| | 30nm | - | - | - | - | - |
| | 70nm | 40 | - | - | 20 | - |
| | 350nm | - | 40 | - | - | 30 |
| | 600nm | - | - | 40 | - | - |
| | 700nm | - | - | - | - | - |
| Silver particle (part(s) by mass) | 1.0*µ*m | 40 | - | - | 60 | - |
| | 3.0*µ*m | - | 40 | - | - | 50 |
| | 5.0*µ*m | - | - | 40 | - | - |
| First resin (part(s) by mass) | Bisphenol A type epoxy resin | 0.1 | - | - | - | - |
| | Bisphenol F type epoxy resin | - | 3 | - | - | - |
| | Aliphatic epoxy resin | - | - | 3.2 | - | - |
| | Novolac type epoxy resin | - | - | - | 1.5 | 2.4 |
| | Phenolic resin | - | - | - | - | - |
| | Urethane resin | - | - | - | - | - |
| Curing agent (part(s) by mass) | Dicyandiamide | 0.1 | - | 0.8 | - | - |
| | Imidazole | - | 1 | - | 0.75 | 0.8 |
| | Hexamethylenetetramine | - | - | - | - | - |
| | Polvisocvanate | - | - | - | - | - |
| Second resin (part(s) by mass) | Hvdroxyethylmethylcellulose | 0.1 | - | 4 | - | - |
| | Ethyl cellulose | - | 2 | - | - | 3 |
| | Ethyl cellulose acrylic polymer | - | - | - | 2 | - |
| | Polyamide | - | - | - | - | - |
| | Acrylic resin | - | - | - | - | - |
| Organic solvent (part(s) by mass) | Terpineol | 19.7 | - | - | 15.75 | - |
| | Diethylene glycol monoethyl ether acetate | - | 14 | - | - | 13.8 |
| | Texanol | - | - | 12 | - | - |
| Characteristics | Specific resistance (Ω·cm) | 3.1×10⁻⁶ | 4.5×10⁻⁶ | 4.2×10⁻⁶ | 4.2×10⁻⁶ | 4.9×10⁻⁶ |
| | Adhesion | A | A | A | A | A |

**[Table 2]**

| | Details of materials | Example 1-6 | Example 1-7 | Example 1-8 | Example 1-9 | Example 1-10 |
|---|---|---|---|---|---|---|
| Silver nanoparticle (part(s) by mass) | 25nm | - | - | - | - | - |
| | 30nm | - | - | - | 10 | 35 |
| | 70nm | - | 55 | - | - | - |
| | 350nm | - | - | 65 | - | - |
| | 600nm | 50 | - | - | - | - |
| | 700nm | - | - | - | - | - |
| Silver particle (part(s) by mass) | 1.0*µ*m | - | - | 20 | 70 | 45 |
| | 3.0*µ*m | - | 20 | - | - | - |
| | 5.0*µ*m | 30 | - | - | - | - |
| First resin (part(s) by mass) | Bisphenol A type epoxy resin | - | - | 0.5 | - | - |
| | Bisphenol F type epoxy resin | - | 2 | - | 0.1 | - |
| | Aliphatic epoxy resin | 1 | - | - | - | - |
| | Novolac type epoxy resin | - | - | - | - | 0.1 |
| | Phenolic resin | - | - | - | - | - |
| | Urethane resin | - | - | - | - | - |
| Curing agent (part(s) by mass) | Dicyandiamide | - | 1 | 0.5 | - | - |
| | Imidazole | 1 | - | - | 0.1 | 0.1 |
| | Hexamethylenetetramine | - | - | - | - | - |
| | Polyisocyanate | - | - | - | - | - |
| Second resin (part(s) by mass) | Hydroxyethylmethylcellulose | - | - | - | - | - |
| | Ethyl cellulose | - | - | 2 | 1 | 1 |
| | Ethyl cellulose acrylic polymer | 1.5 | 1 | 1 | - | - |
| | Polyamide | - | - | - | - | - |
| | Acrylic resin | - | - | - | - | - |
| Organic solvent (part(s) by mass) | Terpineol | - | 21 | 11 | - | - |
| | Diethylene glycol monoethyl ether acetate | - | - | - | - | - |
| | Texanol | 16.5 | - | - | 18.8 | 18.8 |
| Characteristics | Specific resistance (Ω·cm) | 3.5×10⁻⁶ | 4.5×10⁻⁶ | 3.5×10⁻⁶ | 3.8×10⁻⁶ | 4.1×10⁻⁶ |
| | Adhesion | A | A | A | A | A |

**[Table 3]**

| | Details of materials | Example 1-11 | Example 1-12 | Example 1-13 | Example 1-14 | Example 1-15 |
|---|---|---|---|---|---|---|
| Silver nanoparticle (part(s) by mass) | 25nm | - | - | - | - | - |
| | 30nm | - | - | - | - | - |
| | 70nm | 40 | - | - | 20 | - |
| | 350nm | - | 40 | - | - | 30 |
| | 600nm | - | - | 40 | - | - |
| | 700nm | - | - | - | - | - |
| Silver particle (part(s) by mass) | 1.0*µ*m | 40 | - | - | 60 | - |
| | 3.0*µ*m | - | 40 | - | - | 50 |
| | 5.0*µ*m | - | - | 40 | - | - |
| First resin (part(s) by mass) | Bisphenol A type epoxy resin | 0.05 | - | - | - | - |
| | Bisphenol F type epoxy resin | - | 4.5 | - | - | - |
| | Aliphatic epoxy resin | - | - | 4.8 | - | - |
| | Novolac type epoxy resin | - | - | - | 2.7 | 4.1 |
| | Phenolic resin | - | - | - | - | - |
| | Urethane resin | - | - | - | - | - |
| Curing agent (part(s) by mass) | Dicyandiamide | - | - | 1.2 | - | - |
| | Imidazole | 0.05 | 1.5 | - | 1.3 | 1.4 |
| | Hexamethylenetetramine | - | - | - | - | - |
| | Poly isocyanate | - | - | - | - | - |
| Second resin (part(s) by mass) | Hydroxyethylmethylcellulose | 0.1 | - | 4 | - | - |
| | Ethyl cellulose | - | 2 | - | - | 3 |
| | Ethyl cellulose acrylic polymer | - | - | - | 2 | - |
| | Polyamide | - | - | - | - | - |
| | Acrylic resin | - | - | - | - | - |
| Organic solvent (part(s) by mass) | Terpineol | 19.9 | - | - | 16 | - |
| | Diethylene glycol monoethyl ether acetate | - | 12 | - | - | 11.5 |
| | Texanol | - | - | 10 | - | - |
| Characteristics | Specific resistance (Ω·cm) | 2.5×10⁻⁶ | 4.9×10⁻⁶ | 4.5×10⁻⁶ | 4.9×10⁻⁶ | 4.1×10⁻⁶ |
| | Adhesion | A | A | A | A | A |

**[Table 4]**

| | Details of materials | Example 1-16 | Example 1-17 | Example 1-18 | Example 1-19 | Example 1-20 |
|---|---|---|---|---|---|---|
| Silver nanoparticle (part(s) by mass) | 25nm | - | - | - | - | - |
| | 30nm | - | - | - | 10 | 35 |
| | 70nm | - | 55 | - | - | - |
| | 350nm | - | - | 65 | - | - |
| | 600nm | 50 | - | - | - | - |
| | 700nm | - | - | - | - | - |
| Silver particle (part(s) by mass) | 1.0*µ*m | - | - | 20 | 70 | 45 |
| | 3.0*µ*m | - | 20 | - | - | - |
| | 5.0*µ*m | 30 | - | - | - | - |
| First resin (part(s) by mass) | Bisphenol A type epoxy resin | - | - | 1 | - | - |
| | Bisphenol F type epoxy resin | - | 3.3 | - | 0.15 | - |
| | Aliphatic epoxy resin | 2 | - | - | - | - |
| | Novolac type epoxy resin | - | - | - | - | 0.5 |
| | Phenolic resin | - | - | - | - | - |
| | Urethane resin | - | - | - | - | - |
| Curing agent (part(s) by mass) | Dicyandiamide | - | 1.7 | 1 | - | - |
| | Imidazole | 2 | - | - | 0.15 | 0.5 |
| | Hexamethylenetetramine | - | - | - | - | - |
| | Polyisocyanate | - | - | - | - | - |
| Second resin (part(s) by mass) | Hydroxyethylmethylcellulose | - | - | - | - | - |
| | Fthyl cellulose | - | - | 2 | 1 | 1 |
| | Ethyl cellulose acrylic polymer | 1.5 | 1 | 1 | - | - |
| | Polyamide | - | - | - | - | - |
| | Acrylic resin | - | - | - | - | - |
| Organic solvent (part(s) by mass) | Terpineol | - | 19 | 10 | - | - |
| | Diethylene glycol monoethyl ether acetate | - | - | - | - | - |
| | Texanol | 14.5 | - | - | 18.7 | 18 |
| Characteristics | Specific resistance (Ω·cm) | 4.1×10⁻⁶ | 4.5×10⁻⁶ | 3.5×10⁻⁶ | 3.2×10⁻⁶ | 3.1×10⁻⁶ |
| | Adhesion | A | A | A | A | A |

**[Table 5]**

| | Details of materials | Comparative Example 1-1 | Comparative Example 1-2 | Comparative Example 1-3 | Comparative Example 1-4 |
|---|---|---|---|---|---|
| Silver nanoparticle (part(s) by mass) | 25nm | - | 20 | - | - |
| | 30nm | - | - | - | - |
| | 70nm | - | - | 40 | - |
| | 350nm | - | - | - | 20 |
| | 600nm | - | - | - | - |
| | 700nm | 20 | - | - | - |
| Silver particle (part(s) by mass) | 1.0*µ*m | 60 | 60 | 40 | - |
| | 3.0*µ*m | - | - | - | 60 |
| | 5.0*µ*m | - | - | - | - |
| First resin (part(s) by mass) | Bisphenol A type epoxy resin | - | - | - | - |
| | Bisphenol F type epoxy resin | - | - | - | - |
| | Aliphatic epoxy resin | 1 | 1 | - | - |
| | Novolac type epoxy resin | - | - | - | - |
| | Phenolic resin | - | - | 2 | - |
| | Urethane resin | - | - | - | 2 |
| Curing agent (part(s) by mass) | Dicyandiamide | - | - | - | - |
| | Imidazole | 0.25 | 0.25 | - | - |
| | Hexamethylenetetramine | - | - | 2 | - |
| | Polyisocyanate | - | - | - | 2 |
| Second resin (part(s) by mass) | Hydroxyethylmethylcellulose | 1 | 1 | 1 | - |
| | Ethyl cellulose | - | - | - | 1 |
| | Ethyl cellulose acrylic polymer | - | - | - | - |
| | Polyamide | - | - | - | - |
| | Acrylic resin | - | - | - | - |
| Organic solvent (part(s) by mass) | Terpineol | - | - | - | - |
| | Diethylene glycol monoethyl ether acetate | 18.75 | 18.75 | 16 | - |
| | T exanol | - | - | - | 16 |
| Characteristics | Specific resistance (Ω·cm) | 2.1×10⁻⁵ | 1.6×10⁻⁵ | 3.9×10⁻⁵ | 3.4×10⁻⁵ |
| | Adhesion | B | A | B | A |

**[Table 6]**

| | Details of materials | Comparative Example 1-5 | Comparative Example 1-6 | Comparative Example 1-7 | Comparative Example 1-8 |
|---|---|---|---|---|---|
| Silver nanoparticle (part(s) by mass) | 25nm | - | - | - | - |
| | 30nm | - | - | - | - |
| | 70nm | - | - | - | - |
| | 350nm | 30 | 30 | - | - |
| | 600nm | - | - | 40 | 40 |
| | 700nm | - | - | - | - |
| Silver particle (part(s) by mass) | 1.0*µ*m | - | - | - | - |
| | 3.0*µ*m | - | - | - | - |
| | 5.0*µ*m | 50 | 50 | 40 | 40 |
| First resin (part(s) by mass) | Bisphenol A type epoxy resin | - | - | - | - |
| | Bisphenol F type epoxy resin | - | - | - | - |
| | Aliphatic epoxy resin | 2 | 2 | 2 | 2 |
| | Novolac type epoxy resin | - | - | - | - |
| | Phenolic resin | - | - | - | - |
| | Urethane resin | - | - | - | - |
| Curing agent (part(s) by mass) | Dicyandiamide | - | - | - | - |
| | Imidazole | 1 | 1 | 1 | 1 |
| | Hexamethylenetetramine | - | - | - | - |
| | Polyisocyanate | - | - | - | - |
| Second resin (part(s) by mass) | Hydroxyethylmethylcellulose | - | - | - | - |
| | Ethyl cellulose | - | - | - | - |
| | Ethyl cellulose acrylic polymer | - | - | - | - |
| | Polyamide | 3 | 1 | - | - |
| | Acrylic resin | - | - | 3 | 1 |
| Organic solvent (part(s) by mass) | Terpineol | - | - | - | - |
| | Diethylene glycol monoethyl ether acetate | 17 | 17 | - | - |
| | Texanol | - | - | 17 | 17 |
| Characteristics | Specific resistance (Ω·cm) | 7.7×10⁻⁵ | 8.1×10⁻⁶ | 5.6×10⁻⁵ | 7.7×10⁻⁶ |
| | Adhesion | A | B | A | A |

As indicated in Table 1 to Table 4, in the printed wiring boards formed of the conductive pastes of Examples 1-1 to 1-20, the specific resistance of the wiring is small, and the adhesion of the wiring to the substrate is also excellent. On the other hand, as indicated in Table 5 and Table 6, in the printed wiring boards formed of the conductive pastes of Comparative Examples 1-1 to 1-8, the specific resistance of the wiring is large, or the adhesion of the wiring to the substrate is not excellent.

### (Example 2-1)

The conductive paste obtained in Example 1-1 was applied onto a substrate of a polyimide film by a screen printing method so as to have a pattern illustrated in FIG. 3, and calcined in an oven at 140°C or higher for 30 minutes or more to obtain a printed wiring board. For screen printing, a squeegee having a cut-out portion at corners as illustrated in FIG. 2 was used. The length L1 of the first outer surface and the length L2 of the second outer surface forming the cut-out portion are 2 mm, and the interior angle formed by the first outer surface and the second outer surface is 90 degrees.

FIG. 3 is a plan view illustrating the printed wiring boards produced in the example and the comparative example. As illustrated in FIG. 3, in a pattern 1, a conductor pattern having a length of 800 mm and a width of 1.4 mm is formed. In a pattern 2, a conductor pattern having a length of 400 mm and a width of 0.7 mm is formed. In a pattern 3, a conductor pattern having a length of 200 mm and a width of 0.35 mm is formed.

### (Comparative Example 2-1)

A printed wiring board was obtained in the same manner as in Example 2-1 except that CE-I-WB (150) manufactured by Tanaka Kikinzoku Kogyo was used as the conductive paste.

### (Comparative Example 2-2)

A printed wiring board was obtained in the same manner as in Example 2-1 except that Picosil (registered trademark) DNS-0201P manufactured by Daicel Corporation was used as the conductive paste.

### (Comparative Example 2-3)

A printed wiring board was obtained in the same manner as in Example 2-1 except that UNIMEC (registered trademark) H9481 manufactured by Namics was used as the conductive paste.

### [Evaluation]

### (Film thickness)

In the printed wiring board with the pattern illustrated in FIG. 3, the film thickness of the wiring was measured using a stylus type profiler D500 manufactured by KLA-Tencor Corporation.

### (Resistance value)

In a printed wiring board in which wiring was formed so as to have the pattern illustrated in FIG. 3, the resistance value of the wiring was measured using a digital multimeter manufactured by Advantest Corporation.

### (Adhesion)

The adhesive surface of the tape was pressure-bonded to the printed wiring board obtained as described above with fingers so that no bubbles remained, and after about 10 seconds, the tape was quickly peeled off in a direction perpendicular to the printed surface. As a tape, an aluminum tape No. 950, manufactured by Nichiban Co., Ltd., with an adhesive force of 5.30 N/10 mm was used. The case where no print peeling was observed (the case where the peeled circuit could not be checked on the tape side and the case where the peeling of the circuit could not be checked visually on the wiring board side) was evaluated as A. The case where print peeling was observed (the case where the peeled circuit could be checked on the tape side or the case where the peeling of the circuit could be checked visually on the wiring board side) was evaluated as B.

**[Table 7]**

| | | Example 2-1 | Comparative Example 2-1 | Comparative Example 2-2 | Comparative Example 2-3 |
|---|---|---|---|---|---|
| Pattern 1 | Film thickness (µm) | 21.8 | 5.0 | 4.3 | 15.3 |
| | Resistance value (mΩ/m) | 795 | 3920 | 10563 | 1944 |
| Pattern 2 | Film thickness (µm) | 24.5 | 8.3 | 6.2 | 16.6 |
| | Resistance value (mΩ/m) | 708 | 2297 | 7122 | 1705 |
| Pattern 3 | Film thickness (µm) | 23.3 | 7.8 | 5.6 | 14.2 |
| | Resistance value (mΩ/m) | 752 | 2631 | 8117 | 2218 |
| Adhesion | | A | B | B | B |

As illustrated in Table 7, in the printed wiring board according to Example 2-1 the printed wiring board is produced by using a specific conductive paste. Therefore, the wiring having a length of 100 mm or more and 1600 mm or less, a width of 0.3 mm or more and 3 mm or less, and a thickness of 10 µm or more and 40 µm or less could be formed. Therefore, the resistance value of the wiring could be reduced to 1000 mΩ/m or less. It is presumed that the printed wiring board as described above can be used with a high current even with long and narrow wiring. In addition, in the printed wiring board according to Example 2-1, the adhesion of the wiring was sufficient.

On the other hand, in the printed wiring boards according to Comparative Examples 2-1 to 2-3, the resistance value of the wiring exceeded 1000 mΩ/m, and in some printed wiring boards, the wiring having a length of 100 mm or more and 1600 mm or less, a width of 0.3 mm or more and 3 mm or less, and a thickness of 10 µm or more and 40 µm or less could not be formed. In addition, in the printed wiring boards according to Comparative Examples 2-1 to 2-3, the adhesion of the wiring was not sufficient.

As described above, although the present embodiment has been demonstrated, the present disclosure is not limited thereto, and various modifications are possible within the scope defined by the appended claim.

## Claims

1. A method of manufacturing a printed wiring board, comprising:
applying a conductive paste to a surface of a substrate by screen printing, by using a squeegee (32) having a cut-out portion (31) in which a portion of a corner portion is cut off, wherein the cut-out portion (31) is formed by a first outer surface (31a) and a second outer surface (31b) and an interior angle formed by the first outer surface (31a) and the second outer surface (31b) is 45 to 135 degrees, and wherein the squeegee (32) is arranged so that the portion where the cut-out portion (31) is formed is in contact with a screen plate (34); and
curing the applied conductive paste to form wiring,
wherein the conductive paste contains metal nanoparticles having an average particle diameter of 30 nm or more and 600 nm or less, metal particles having an average particle diameter larger than that of the metal nanoparticles, a thermosetting resin having an oxirane ring in a molecule, a curing agent, and a cellulose resin, and
the wiring has a length of 100 mm or more and 1600 mm or less, a width of 0.3 mm or more and 3 mm or less, a thickness of 10 µm or more and 40 µm or less, and a resistance value of 1000 mΩ/m or less.

## Patentansprüche

1. Verfahren zum Herstellen einer gedruckten Leiterplatte, das umfasst:
Aufbringen einer leitfähigen Paste auf eine Oberfläche eines Substrats mittels Siebdrucken unter Verwendung einer Rakel (32) mit einem ausgeschnittenen Abschnitt (31), in dem ein Teil eines Eckenabschnitts abgeschnitten ist, wobei der ausgeschnittene Abschnitt (31) durch eine erste äußere Fläche (31a) und eine zweite äußere Fläche (31b) gebildet wird und ein Innenwinkel, der durch die erste äußere Fläche (31a) und die zweite äußere Fläche (31b) gebildet wird, 45° bis 135° beträgt, und die Rakel (32) so angeordnet ist, dass der Teil, in dem der ausgeschnittene Abschnitt (31) ausgebildet ist, in Kontakt mit einer Siebplatte (34) ist; und
Aushärten der aufgebrachten leitfähigen Paste zum Ausbilden einer Verdrahtung,
wobei die leitfähige Paste Metall-Nanopartikel mit einem durchschnittlichen Partikeldurchmesser von 30 nm oder mehr und 600 nm oder weniger, Metallpartikel mit einem durchschnittlichen Partikeldurchmesser, der größer ist als der der Metall-Nanopartikel, ein wärmehärtendes Harz mit einem Oxiranring in einem Molekül, ein Härtungsmittel sowie ein Zelluloseharz enthält, und
die Verdrahtung eine Länge von 100 mm oder mehr und 1.600 mm oder weniger, eine Breite von 0,3 mm oder mehr und 3 mm oder weniger, eine Dicke von 10 µm oder mehr und 40 µm oder weniger sowie einen Widerstandswert von 1000 mΩ/m oder weniger hat.

## Revendications

1. Procédé de fabrication d'une carte de câblage imprimé, comprenant :
l'application d'une pâte conductrice sur une surface d'un substrat par sérigraphie, en utilisant une raclette (32) ayant une partie découpée (31) dans laquelle une partie d'une partie de coin est découpée, où la partie découpée (31) est formée par une première surface extérieure (31a) et une deuxième surface extérieure (31b) et un angle intérieur formé par la première surface extérieure (31a) et la deuxième surface extérieure (31b) est compris entre 45 et 135 degrés, et où la raclette (32) est agencée de sorte que la partie où la partie découpée (31) est formée soit en contact avec une planche tramée (34) ; et
le durcissement de la pâte conductrice appliquée pour former un câblage,
dans lequel la pâte conductrice contient des nanoparticules métalliques ayant un diamètre moyen des particules supérieur ou égal à 30 nm et inférieur ou égal à 600 nm, des particules métalliques ayant un diamètre moyen des particules supérieur à celui des nanoparticules métalliques, une résine thermodurcissable ayant un cycle oxirane dans une molécule, un agent de durcissement, et une résine de cellulose, et
le câblage a une longueur supérieure ou égale à 100 mm et inférieure ou égale à 1600 mm, une largeur supérieure ou égale à 0,3 mm et inférieure ou égale à 3 mm, une épaisseur supérieure ou égale à 10 µm et inférieure ou égale à 40 µm, et une valeur de résistance inférieure ou égale à 1000 mΩ/m.
